# DEMANDE DE BREVET EUROPEEN

(11) **EP 0 758 749 A1**
(43) Date de publication de la demande: **19.02.1997**
(21) Numéro de dépôt: 96401766.9
(22) Date de dépôt: 12.08.1996
(51) Int. Cl.: G01R 15/18

(54) **Capteur de courant et appareil électrique le comportant**

(30) Priorité: 14.08.1995 FR 9509869
(71) Demandeur: SCHNEIDER ELECTRIC SA, 92100 Boulogne Billancourt (FR)
(72) Inventeur: Baurand, Gilles, 78360 Montesson la Borde (FR); Gaschet, Gérald, 92800 Puteaux (FR); Leglaye, Dominique, 92500 Rueil Malmaison (FR)
(74) Mandataire: Carias, Alain

(57) **Abrégé**

Le circuit magnétique du capteur comprend une partie séparable 22 portant l'élément détecteur 25 et il est réalisé en un matériau de perméabilité comprise entre 5 et 100.

## Description

La présente invention concerne un capteur de courant inductif pour appareil électrique comportant un circuit magnétique dont une partie sert de support à un élément détecteur de champ magnétique tel qu'une bobine détectrice et un conducteur entouré par le circuit magnétique et parcouru par le courant à détecter. Elle concerne également l'appareil électrique équipé d'un tel capteur ou de tels capteurs.

Les capteurs de courant du type précité sont bien connus et sont utilisés dans des appareils électriques de puissance tels que des disjoncteurs, des relais de surintensité ou des variateurs de vitesse pour détecter des courants excessifs afin que soit alors interrompue l'alimentation de la charge connectée à l'appareil.

Quand on monte l'appareil, il est souhaitable de pouvoir introduire facilement le conducteur de courant dans le capteur; or le plus souvent les capteurs de courant comprennent un circuit magnétique fermé dans lequel il faut enfiler le conducteur et l'opération de montage est donc incommode. D'autre part, les appareils de protection peuvent nécessiter des capteurs différents en fonction des charges raccordables et il est souhaitable, soit au stade de la fabrication de l'appareil, soit au stade de son installation, d'adapter ou de personnaliser l'appareil en fonction de son application.

Lorsqu'un capteur de courant du type décrit est constitué par un transformateur d'intensité, le matériau du circuit magnétique présente une forte perméabilité, typiquement supérieure à 5000. Un transformateur d'intensité est dès lors sensible aux perturbations et, lorsqu'on souhaite réaliser son circuit magnétique avec une partie séparable, l'entrefer parasite formé au raccordement de la partie séparable à la partie fixe a une influence fâcheuse sur la mesure.

Lorsque le capteur de courant est formé par un tore de Rogowski, la perméabilité est de l'ordre de 1 et la nécessité d'avoir un grand nombre de spires pour l'enroulement secondaire ne permet pas de les disposer facilement sur une partie séparable ; de plus, le bobinage doit être exécuté de manière continue sur le tore pour assurer l'insensibilité aux perturbations électromagnétiques.

L'invention a pour but de réduire l'influence des entrefers parasites et des perturbations externes sur un capteur de courant pour appareil électrique. Elle a aussi pour but de faciliter le montage du capteur de courant dans l'appareil électrique et l'adaptation de celui-ci à des caractéristiques de charge différentes.

Selon l'invention, le circuit magnétique comprend une partie magnétique ouverte et une partie magnétique de fermeture distincte de la partie magnétique ouverte et portant l'élément détecteur, l'une au moins des deux parties du circuit magnétique étant en un matériau à faible perméabilité, laquelle peut être comprise entre 5 et 100, de préférence entre 8 et 30. Il en résulte que le circuit magnétique peut ainsi être considéré comme présentant un entrefer réparti et que le capteur est très peu sensible à l'entrefer parasite éventuellement observé à l'interface entre la partie de fermeture et la partie ouverte du circuit magnétique.

L'appareil électrique selon l'invention est muni d'au moins un tel capteur de courant, dont la partie magnétique ouverte est disposée à demeure dans le boîtier de l'appareil et dont la partie magnétique de fermeture est fixée soit à une carte à circuit imprimé comportant un circuit de traitement du signal électrique délivré par l'élément détecteur, ce circuit de traitement engendrant un signal de déclenchement quand une surintensité a été détectée, ou à une partie ou à un couvercle amovible accessible de l'extérieur du boîtier, cette partie ou ce couvercle portant de préférence du côté de la partie de fermeture la carte à circuit imprimé.

Il doit être bien compris que la partie magnétique ouverte disposée à demeure dans le boîtier de l'appareil peut avantageusement appartenir à un socle d'application générale de l'appareil, en particulier utilisable pour une large gamme d'intensités nominales, tandis que la partie magnétique de fermeture peut alors appartenir à une partie de traitement électronique agencée spécifiquement en fonction du calibre, notamment du calibre en courant, de l'appareil. En d'autres termes, on peut poser sur un même socle différents blocs de traitement électroniques adaptés chacun à un calibrage électrique différent. Cette pose peut avoir lieu chez le fabricant ou chez l'utilisateur.

La description qui va être faite ci-après d'un mode de réalisation, en regard des dessins, permettra d'expliciter les caractéristiques et avantages de l'invention.
- la figure 1 illustre schématiquement un capteur de courant inductif conforme à l'invention.
- la figure 2 montre en coupe un capteur monté dans un appareil selon l'invention.
- la figure 3 montre schématiquement un appareil contacteur-disjoncteur.

Le capteur de courant 20 est logé dans un boîtier isolant 10 de l'appareil électrique à basse tension, ce boîtier présentant une face frontale 11 accessible de l'extérieur à un opérateur.

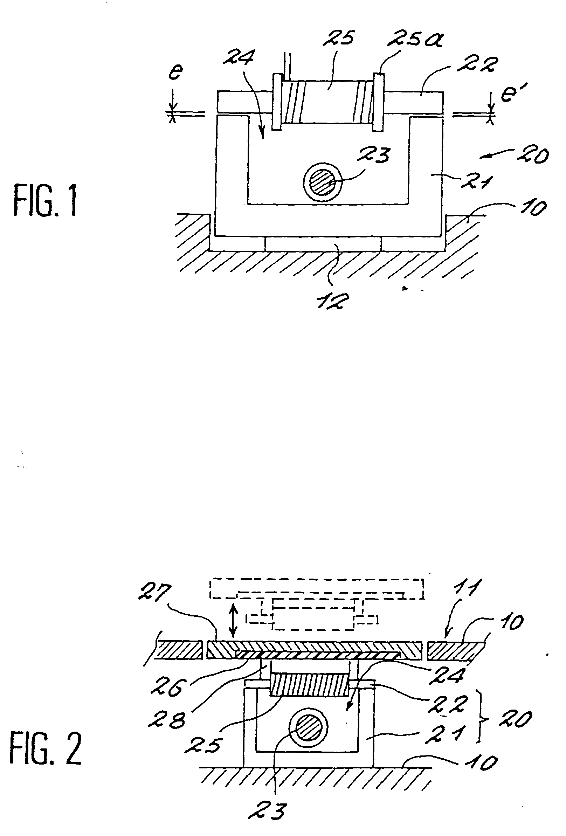

Le capteur 20 comporte un circuit magnétique fixe ouvert 21, par exemple en forme de U ou de L, fixé par tout moyen approprié dans le boîtier 10 de l'appareil et un circuit magnétique de fermeture 22 formé par exemple par une palette rapportée de manière à ponter le circuit fixe pour établir un chemin magnétique sans entrefer nominal pour le flux magnétique. Lorsque le circuit 21 est en forme de L, on peut utiliser une pièce identique en L pour le circuit 22. Un conducteur de puissance 23 appartenant à un chemin de courant à basse fréquence, par exemple 50 ou 60Hz, de l'appareil est inséré dans l'ouverture 24 du circuit magnétique fixe 21 dans celui-ci et il y reste maintenu dans une position bien déterminée par des moyens de retenue. Un bobinage 25 enroulé sur une carcasse 25a associée au circuit magnétique de fermeture 22 est monté sur une carte à circuit imprimé 26 elle-même fixée à un couvercle amovible ou un boîtier 27 en matériau isolant accessible de l'extérieur du boîtier, du côté de la paroi frontale 11 de celui-ci ; le couvercle 27 forme par exemple une partie de la face avant du boîtier (voir figure 2). Le circuit magnétique 22 est fixé à la carte 26 par des pieds 28. Les circuits 21, 22 ont une faible perméabilité magnétique de préférence comprise entre 8 et 30 et sont à cet effet par exemple réalisés à base de fer carbonyle ou autre matériau analogue à faible perméabilité. Un élément élastique 12 peut être disposé entre le circuit magnétique ouvert 21 et le boîtier, en conjugaison avec une butée non représentée pour ce circuit 21, pour contribuer à réduire l'entrefer parasite e ou e'.

Selon les cas, les circuits 21, 22 sont tous deux en matériau à faible perméabilité ou seul l'un des circuits 21, 22 est en un tel matériau. On constate que la mesure de courant est insensible à la présence de faibles entrefers parasites e et e'.

L'appareil électrique considéré peut être un disjoncteur, un contacteur-disjoncteur, un relais de protection ou un variateur de vitesse et il peut présenter plusieurs capteurs, la carte à circuit imprimé 26 portant le circuit de traitement 30 des signaux fournis par les différents capteurs afin d'engendrer un signal de déclenchement. Le couvercle amovible 27 peut être un simple plastron (figure 2) ou peut être agencé en tant que boîtier support d'autres organes.

On a représenté en tirets sur la figure 2 la partie de fermeture 22 du circuit magnétique et son couvercle porteur amovible 27 en position extraite et l'on comprend que cette disposition facilite tant la mise en place du conducteur 23 que le changement de l'élément détecteur 25. Bien entendu, le même couvercle peut porter deux ou trois capteurs associés à des phases respectives. Un seul rail magnétique amovible 22 peut être prévu pour plusieurs phases, ce rail portant les bobines respectives 25. L'élément détecteur illustré sous forme de bobine 25 peut être constitué par un détecteur à effet Hall ou autre élément analogue détectant le champ magnétique engendré par le passage du courant dans le conducteur 23.

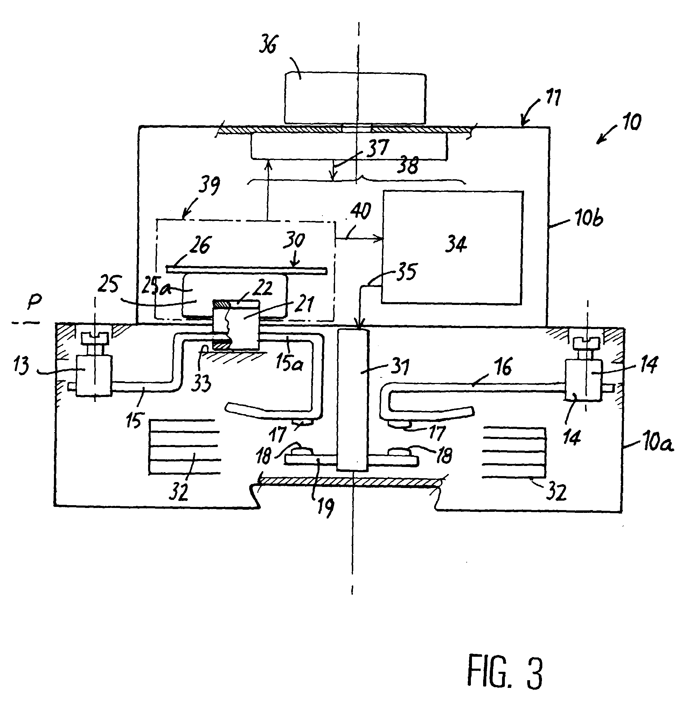

La figure 3 montre un contacteur-disjoncteur polyphasé dont le boîtier 10 comporte un socle 10a auquel est assemblée une partie avant 10b qui peut elle-même se composer d'un bloc ou de plusieurs blocs fonctionnels. Le socle 10a comprend pour chaque phase deux bornes de puissance 13,14 auxquelles sont associées des pièces conductrices respectives 15, 16 portant des contacts fixes 17 en regard desquels se trouvent des contacts mobiles 18 situés sur un pont de contact 19. Les ponts de contact 19 sont portés par un support mobile 31. Près des contacts sont situées des chambres de coupure munies de blocs d'ailettes 32. La pièce conductrice 15 est rehaussée dans une zone 15a proche du plan de joint P des parties 10a, 10b du boîtier pour traverser une partie fixe 21 en forme de U du circuit magnétique ; cette partie 21 repose sur des surfaces 33 du socle 10a et dépasse légèrement du plan P vers la partie 10b du boîtier.

La partie avant 10b du boîtier 10 de l'appareil comprend un électroaimant 34 susceptible d'agir directement comme l'indique la flèche 35 sur le support 31 des contacts. A l'avant de la partie 10b du boîtier est prévu un bouton de commande manuelle 36 coopérant comme indiqué par la flèche 37 avec l'ensemble 38 formé par l'électroaimant 34 et un bloc de traitement électronique 39. Celui-ci comporte les parties de fermeture 22 des circuits magnétiques, les bobines de détection 25 et la carte 26 portant le circuit de traitement de surintensité 30. Le circuit 30 est connecté comme l'indique la flèche 40 à la bobine de l'électroaimant 34. Le socle 10a de l'appareil est le même pour plusieurs types d'appareils et l'on comprend que la différenciation des appareils s'effectue au niveau de la partie 10b du boîtier, grâce aux parties interchangeables 22 et à leurs enroulements secondaires 25 et aux circuits de traitement spécifiques 30.

## Revendications

1. Capteur de courant pour appareil électrique comportant :
- un circuit magnétique dont une partie sert de support à un élément détecteur (25),
- un conducteur (23) ceinturé par le circuit magnétique et parcouru par le courant à détecter,
- le circuit magnétique comprenant une partie magnétique ouverte (21) et une partie magnétique (22) de fermeture distincte de la partie magnétique ouverte et portant l'élément détecteur (25),
caractérisé par le fait que l'une au moins des deux parties (21, 22) du circuit magnétique est en matériau à faible perméabilité.

2. Capteur selon la revendication 1, caractérisé par le fait que la perméabilité du matériau du circuit magnétique est comprise entre 5 et 100, de préférence entre 8 et 30.

3. Capteur selon la revendication 2, caractérisé par le fait que le matériau à faible perméabilité du circuit magnétique est à base de fer carbonyle.

4. Appareil électrique muni d'au moins un capteur de courant comportant :
- un circuit magnétique dont une partie sert de support à un élément détecteur (25),
- un conducteur (23) ceinturé par le circuit magnétique et parcouru par le courant à détecter,
- le circuit magnétique comprenant une partie magnétique ouverte (21) et une partie magnétique (22) de fermeture distincte de la partie magnétique ouverte et portant l'élément détecteur (25),
caractérisé par le fait que l'une au moins des deux parties (21, 22) du circuit magnétique est en matériau à faible perméabilité, la partie magnétique ouverte (21) est disposée à demeure dans le boîtier (10) de l'appareil et la partie magnétique de fermeture (22) est fixée à un bloc de traitement électronique interchangeable (39).

5. Appareil selon la revendication 4, caractérisé par le fait que le bloc de traitement électronique interchangeable (39) porte, du côté de la partie magnétique de fermeture (22), une carte à circuit imprimé (26) comportant un circuit (30) de traitement du signal électrique délivré par l'élément détecteur (25).

6. Appareil selon la revendication 4, caractérisé par le fait que la partie ouverte (21) du circuit magnétique du capteur est associée à un conducteur de puissance (23) logé dans un socle (10b) de l'appareil, ce socle comprenant des contacts fixes (17) et mobiles (18) associés au conducteur et des chambres de coupure adjacentes aux contacts, tandis que la partie de fermeture (22) du circuit magnétique du capteur est logée avec le bloc de traitement interchangeable (39) dans une partie avant (10b) du boîtier rapportée à son socle (10a).

7. Appareil selon la revendication 6, caractérisé par le fait que la partie ouverte (21) du circuit magnétique enveloppe une région (15a) surélevée d'une pièce conductrice (15) logée dans le socle (10a) près d'un plan de joint (P) du socle et de la partie avant (10b) du boîtier.
